(19) Europäisches Patentamt

European Patent Office

Office européen des brevets

(11) Numéro de publication : **0 317 420 B1**

(12) **FASCICULE DE BREVET EUROPEEN**

(45) Date de publication du fascicule du brevet :
**15.01.92 Bulletin 92/03**

(21) Numéro de dépôt : **88402861.4**

(22) Date de dépôt : **15.11.88**

(51) Int. Cl.⁵ : **H03M 1/06, H03M 1/74**

(54) Convertisseur numérique analogique à haute stabilité de tension de sortie.

(30) Priorité : **17.11.87 FR 8715846**

(43) Date de publication de la demande :
**24.05.89 Bulletin 89/21**

(45) Mention de la délivrance du brevet :
**15.01.92 Bulletin 92/03**

(84) Etats contractants désignés :
**DE GB NL**

(56) Documents cités :
**EP-A- 0 228 960**
**DE-A- 2 412 226**
**FR-A- 2 453 546**
**GB-A- 896 246**

(73) Titulaire : **THOMSON HYBRIDES ET**
**MICROONDES**
**173, bld Haussmann**
**F-75008 Paris (FR)**

(72) Inventeur : **Tung, Pham Ngu Thomson - CSF**
**SCPI - 19, avenue de Messine**
**F-75008 Paris (FR)**

(74) Mandataire : **Taboureau, James et al**
**THOMSON-CSF SCPI**
**F-92045 Paris La Défense Cédex 67 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un convertisseur numérique analogique, plus particulièrement déstiné à travailler en hyperfréquence en raison de sa structure très simple, qui autorise une conversion numérique analogique à des débits très élevés. Le convertisseur numérique analogique selon l'invention comporte un étage de sortie qui stabilise la tension analogique délivrée. Sa réalisation est plus particulièrement intéressante sous forme de circuit intégré rapide, réalisé au moyen de transistors à héterojonction en matériaux du groupe III-V tel que GaAs et Al GaAs par exemple.

Il est connu de convertir un nombre binaire en une valeur analogique au moyen d'une pluralité de sources de courant programmées, montées en parallèle : chaque source est commandée par l'un des bits du nombre binaire. Un transistor, transformateur courant-tension, additionne les courants de toutes les sources et transforme le courant résultant en une tension analogique.

Cette tension est d'autant plus précise que le nombre de bits du signal binaire d'entrée est élevé. Mais elle est soumise à des instabilités dont les sources se retrouvent dans tous les composants du convertisseur: instabilité des deux sources de tension + VDD et − VSS entre lesquelles est alimenté le convertisseur, instabilité des transistors des sources de courant programmées et du transformateur courant-tension.

C'est donc un objet de l'invention que de proposer un convertisseur numérique analogique dont la tension de sortie est stabilisée par un circuit dont le schéma ressemble à une porte BFL, mais qui fonctionne différemment, la sortie de ce circuit étant rebouclée sur la grille du transistor inverseur du premier étage, qui constitue le convertisseur courant tension. La tension analogique recueillie sur le drain de ce transistor inverseur est adressée sur la grille d'un transistor monté en source suiveuse dans un second étage décaleur qui comporte en outre au moins une diode de décalage et un transistor de rappel. La tension de sortie du convertisseur numérique analogique prelevée au point commun entre diodes de décalage et transistor de rappel, est rebouclée sur la grille du transistor inverseur, convertisseur courant-tension : comme il agit en inverseur, si la tension de sortie évolue dans un sens, le transistor inverseur la fait évoluer en sens inverse et la stabilise

De façon plus précise l'invention concerne un convertisseur numérique analogique à haute stabilité de tension de sortie, comportant un premier étage constitué par une pluralité de charges modulables en parallèle qui débitent des courants en progression géométrique dans un unique transistor inverseur, transformateur courant-tension dont la source est à la masse, chaque charge modulable étant formée par un transistor dont la grille constitue une entrée pour le nombre binaire, dont le drain est alimenté par une tension positive et dont la source est réunie, à travers une charge saturable au transistor inverseur, le drain duquel constitue la sortie du premier étage, ce convertisseur étant caractérisé en ce qu'il comprend, alimenté entre une tension positive et une tension négative, un second étage dont l'entrée est réunie à la sortie du première étage, et dont la sortie délivre une tension de sortie stabilisée qui est rebouclée sur la grille du transistor inverseur du premier étage.

L'invention sera mieux comprise par la description plus détaillée qui en suit maintenant, cette description s'appuyant sur les figures jointes en annexe qui représentent :

— figure 1 : schéma électrique d'un convertisseur numérique analogique selon l'art connu.

— figure 2 : schéma électrique d'un convertisseur numérique analogique selon l'invention.

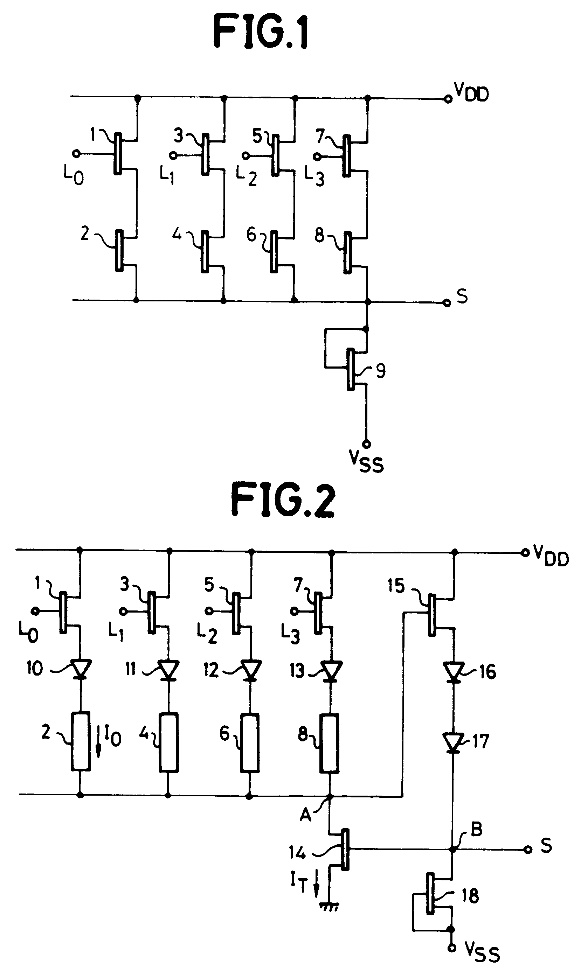

La figure 1 donne à titre de rappel de l'art connu, le schéma électrique d'un convertisseur numérique analogique fonctionnant dans le domaine des hyperfréquences, tel qu'il a été décrit dans la demande de brevet français n° FR-A-2592250 déposée le 24 decembre 1985 par la demanderesse.

Ce convertisseur numérique analogique, qui est iҫi représenté dans un modèle à quatre bits, comporte une pluralité de transistors 1, 3, 5 et 7 montés en parallèle ; ils ne constituent donc qu'un seul étage, ce qui permet une conversion plus rapide. Alimentés par leurs drains, ces transistors ont leurs sources réunies à des résistances saturables 2, 4, 6 et 8, une par transistor, dont les valeurs sont en progression géométrique, c'est à dire que si la résistance saturable correspondant au bit de poid le plus léger laisse passer un courant Io, les résistances saturables suivantes laissent passer des courants qui sont respectivement de $2I_o$, $4I_o$, $8I_o$ etc.... Les signaux binaires adressés en $L_0$, $L_1$, $L_2$, $L_3$ sur les grilles des transistors font que ceux-ci débitent à travers les résistances des courants en progression géométrique. Toutes les résistances saturables de 2 à 8 étant réunies par leur extrémité qui n'est pas connectée à une source de transistor, le courant débité par ce circuit est égal à la somme de tous les courants débités par les résistances en parallèle.

Le courant résultant est transformé en une tension analogique au moyen d'un transistor 9 convertisseur de courant en tension. Il est monté drain et grille réunis, connectés au point commun à toutes les résistances saturables, et sa source est réunie à une tension de référence $V_{SS}$. La sortie du convertisseur numérique analogique est prise au point commun entre les résistances saturables et le drain de transistor convertisseur de courant en tension

Ce type de convertisseur fonctionne très rapidement puisqu'il ne comporte qu'un seul étage de transistor de 1 à 7 entre l'entrée et la sortie, les charges saturables 2 à 8 étant soit des transistors dépourvus de métallisation de grille, soit des transistors qui comportent un recess dans le matériau semiconducteur entre les deux métallisations de source et drain. Cependant la tension de sortie prélevée au point S peut subir de légères variations dues aux variations, ou instabilités sur les tensions $V_{DD}$ qui alimentent les drains des transistors d'entrée, sur la tension VSS connectée à la source du transistor sommateur 9, ou encore dues aux instabilités inhérentes au fonctionnement des transitors 1 à 7 ainsi que 9. Or la precision de la tension analogique de sortie d'un convertisseur numérique analogique est d'autant plus élevée que le nombre de bits d'entrée est élevé et il est regretable que cette tension soit soumise à des variations dues aux variations des composants du circuit.

C'est donc ce que propose l'invention : stabiliser la tension de sortie d'un convertisseur numérique analogique basé sur le schéma du convertisseur numérique analogique qui vient d'être décrit. Pour cela un étage de stabilisation en sortie lui est ajouté, ainsi qu'une légère modification du cablage du transistor convertisseur courant-tension ; comme représenté en figure 2 qui donne le schéma du convertisseur selon l'invention.

Le premier étage du convertisseur numérique analogique comporte une charge modulable qui alimente un transistor 14 convertisseur courant tension, la charge modulable est en tout point comparable à celle qui est décrite au sujet de l'art connu et elle peut comporter entre chaque transistor et sa charge saturable une diode 10 à 13. A titre d'exemple non limitatif cette charge correspond à un nombre de 4 bits dont les transistors d'entrée 1 à 7 sont alimentés par la tension $V_{DD}$ sur leur drain. Leur source est réunie à une diode 10 à 13 et débitent dans une charge saturable 2 à 8 qui a été représentée de façon conventionnelle puisque différents types de charges saturables existent. Les grilles des transistors d'entrées 1 à 7 constituent les entrées des bits $L_0$ à $L_3$ qui représentent le nombre binaire N.

$$N = L_0 + L_1 + L_2 + L_3.$$

Le transistor 14 convertisseur courant-tension a sa source à la masse et son drain alimenté par la charge modulable. Il a une tension de seuil $V_T$ négative et une transconductance $G_O$ constante, ce qui constitue un aspect important de l'invention.

Le second étage de convertisseur numérique analogique est un étage de décalage constitué par un transistor 15 de même tension de seuil $V_T$ que celle du transistor 14. Il est monté en source suiveuse, son drain étant alimenté par $V_{DD}$, et sa source en série avec une ou plusieurs diodes 16, 17, ainsi qu'avec une charge de rappel formée par un transistor 18, dont la source est reliée à une tension négative $V_{SS}$. La grille du transistor 18 est connectée sur la source de ce même transistor. La sortie S du convertisseur est prise en un point B commun à la cathode de la dernière diode de décalage 17 et au drain du transitor de rappel 18 mais ce point B est également connecté sur la grille du transistor transformateur courant-tension 14 de telle sorte que le courant de sortie contre-réactionne le transistor 14, sommateur des courants fournis par le premier étage, au point A.

Les transistors d'entrée des charges modulables 1 à 7 fonctionnent comme des interrupteurs. Si l'on appelle $I_o$ le courant élémentaire qui traverse la première charge saturable 2, $2I_o = I_1$ le courant qui traverse la seconde charge saturable 4, $4I_o = I_2$ le courant qui traverse la troisième charge saturable 6 et ainsi de suite, et $I_T$ le courant total qui traverse le transistor 14, on peut écrire :

$$I_T = L_0 I_0 + L_1 I_1 + L_2 I_2 + L_3 I_3 = NI_o$$

mais l'équation du transistor 14 permet d'écrire

$$NI_o = G_O (V_S - V_T)$$

$V_S$ étant la tension de sortie qui est également la tension de grille de ce transistor 14.

Il y a donc bien correspondance bi-univoque entre le nombre N sous sa forme binaire et le signal de sortie $V_S$ à la sortie du convertisseur numérique analogique.

Le rôle de l'étage de décalage est de stabiliser la tension de sortie $V_S$. On peut considérer que le transistor 14 et sa charge, qui est içi l'ensemble de la charge modulable, constitue le premier étage d'un circuit de type BFL (BUFFERED FET LOGIC) dont le second étage décaleur est constitué par le transistor 15, au moins une diode 16 et le transistor de rappel 18. La différence entre le circuit représenté sur la figure 2 et une porte BFL est que dans la porte BFL il n'y a pas de liaison directe entre la sortie et la grille de transistor d'entrée 14. Par conséquent si $V_S$ qui est la tension mesurée au point B croît, le courant $I_T$ qui traverse le transistor 14 croît puisque la tension appliquée sur sa grille croît. La tension au point A, commune au drain du transistor 14 et à sa charge, est ramenée à une tension plus basse d'après le principe de l'inversion logique puisque le transistor 14 peut être considéré comme l'inverseur d'un premier étage d'une porte BFL. Comme la tension de sortie $V_S$ suit la tension en A parce que le transistor 15 est en source suiveuse, finalement la tension de sortie $V_S$ est ramenée à une tension plus basse : il y a donc régulation et équilibre de la tension de sortie $V_S$.

De la même façon si la tension de sortie $V_S$ baisse, la tension sur le drain au point A augmente et entraine $V_S$ vers le haut : à l'équilibre la tension de sortie $V_S$ est stabilisée. Le tableau suivant donne une correspondance entre les nombres N sur les entrées $L_I$ des transistors d'entrée de la charge modulable et la tension de sortie $V_S$ prélevée au point B du convertisseur numérique analogique.

Posons : $V_S - V_T = V_O$ pour simplifier l'écriture.

| N | $S_0$ | $S_1$ | $S_2$ | $S_3$ | $V_S - V_T = V_O$ |
|----|----|----|----|----|------|
| 0 | 0 | 0 | 0 | 0 | 0 |
| 1 | 1 | 0 | 0 | 0 | $V_O$ |
| 2 | 0 | 1 | 0 | 0 | $2V_O$ |
| 3 | 1 | 1 | 0 | 0 | $3V_O$ |
| 4 | 0 | 0 | 1 | 0 | $4V_O$ |
| 5 | 1 | 0 | 1 | 0 | $5V_O$ |
| 6 | 0 | 1 | 1 | 0 | $6V_O$ |
| 7 | 1 | 1 | 1 | 0 | $7V_O$ |
| 8 | 0 | 0 | 0 | 1 | $8V_O$ |
| 9 | 1 | 0 | 0 | 1 | $9V_O$ |
| 10 | 0 | 1 | 0 | 1 | $10V_O$ |
| 11 | 1 | 1 | 0 | 1 | $11V_O$ |
| 12 | 0 | 0 | 1 | 1 | $12V_O$ |
| 13 | 1 | 0 | 1 | 1 | $13V_O$ |
| 14 | 0 | 1 | 1 | 1 | $14V_O$ |
| 15 | 1 | 1 | 1 | 1 | $15V_O$ |

Mais

$$G_O V_O = I_O$$

Par conséquent le choix de $V_O$ fixe $I_O$ et $G_O$. Réciproquement on peut réaliser un convertisseur numérique analogique en fixant le gain et le courant unitaire $I_O$ des constituants de la charge modulable. Pour une tension de seuil $V_T = 2,5$ Volts, la tension de sortie dans un convertisseur numérique analogique de 8 bits varie entre −2,5 volts et +50 millivolts, avec des intervalles de tensions de 10 millivolts entre chaque nombre exprimé sous forme analogique.

Le convertisseur numérique analogique qui vient d'être décrit est préfèrablement réalisé sous forme de circuit intégré, en matériau rapide et avec des transistors du type à gaz d'électrons. Il est utilisé dans les matériels hyperfréquences pour le traitement de l'information fournie sous une forme binaire, de façon générale dans les télécommunications ou pour le traitement du signal dans les radars par exemple. Il est précisé par les revendications suivantes.

## Revendications

1. Convertisseur numérique-analogique à haute stabilité de tension de sortie ($V_S$), comportant un premier étage constitué par une pluralité de charges modulables en parallèle qui débitent des courants en progression géométrique dans un unique transistor inverseur (14), transformateur courant-tension dont la source est à la masse, chaque charge modulable étant formée par un transistor (1, 3, 5, 7) dont la grille constitue une entrée ($L_0$, $L_1$, $L_2$, $L_3$) pour le nombre binaire, dont le drain est alimenté par une tension positive ($V_{DD}$) et dont la source est réunie, à travers une charge saturable (2, 4, 6, 8) au transistor inverseur (14), le drain duquel constitue la sortie (point A) du premier étage, ce convertisseur étant caractérisé en ce qu'il comprend, alimenté entre une tension positive ($V_{DD}$) et une tension négative ($V_{SS}$), un second étage dont l'entrée est réunie à la sortie (point A) du première étage, et dont la sortie (point B) délivre une tension de sortie stabilisée ($V_S$) qui est rebouclée (point B) sur la grille du transistor inverseur (14) du premier étage.

2. Convertisseur numérique-analogique selon la revendication 1, caractérisé en ce que le second étage est un décaleur formé par un premier transistor (15) monté en source suiveuse, dont la grille est réunie au drain (point A) du transistor inverseur (14) du premier étage, dont le drain est alimenté par une tension positive ($V_{DD}$), et dont la source est réunie, à travers au moins une diode de décalage (16) à un transistor de rappel (18), dont la grille et la source sont alimentées par une tension négative ($V_{SS}$), la tension de sortie ($V_S$) du second étage, prélevée (point B) sur le drain du transistor de rappel (18), étant rebouclée sur la grille du transistor inverseur (14), du premier étage.

3. Convertisseur numérique-analogique selon la revendication 2, caractérisé en ce que le transistor inverseur (14) à une tension de seuil ($V_T$) négative et une transconductance ($G_0$) constante, et en ce que le transistor (15) en source suiveuse a la même tension de seuil négative, les transistors d'entrée, (1, 3, 5, 7) ayant une tension de seuil positive voisine de + 0,1 V.

4. Convertisseur numérique-analogique selon la revendication 2, caractérisé en ce que le nombre de diodes de décalage (16, 17) dans l'étage décaleur dépend de la tension de seuil ($V_T$) du transistor (15) en source suiveuse.

5. Convertisseur numérique-analogique selon la revendication 2, caractérisé en ce que le choix de là transconductance ($G_0$) du transistor (14) inverseur détermine la sensibilité de la tension de sortie ($V_S$).

## Patentansprüche

1. Digital-Analog-Wandler mit sehr stabiler Ausgangsspannung ($V_S$), mit einer ersten Stufe bestehend aus einer Vielzahl von parallelgeschalteten modulierbaren Lasten, die in geometrischer Progression Ströme in einen gemeinsamen als Strom/Spannungswandler wirkenden Invertertransistor (14) liefern, dessen Source an Masse liegt, wobei jede modulierbare Last von einem Transistor (1, 3, 5, 7) gebildet wird, dessen Gate einen Eingang ($L_0$, $L_1$, $L_2$, $L_3$) für die Binärzahl bildet, dessen Drain mit einer positiven Spannung ($V_{DD}$) versorgt wird, und dessen Source über eine sättigbare Last (2, 4, 6, 8) an den Invertertransistor (14) angeschlossen ist, dessen Drain den Ausgang (Punkt A) der ersten Stufe bildet, dadurch gekennzeichnet, daß der Wandler eine zweite, zwischen eine positive ($V_{DD}$) und eine negative ($V_{SS}$) Speisespannung geschaltete Stufe aufweist, deren Eingang mit dem Ausgang (Punkt A) der ersten Stufe verbunden ist und deren Ausgang (Punkt B) eine stabilisierte Ausgangsspannung ($V_S$) liefert, die an das Gate des Invertertransistors (14) der ersten Stufe rückgeschleift ist.

2. Digital-Analog-Wandler nach Anspruch 1, dadurch gekennzeichnet, daß die zweite Stufe eine Shifteinheit ist, die aus einem ersten, als Source-Folgeschaltung ausgebildeten Transistor (15) besteht, dessen Gate an den Drain (Punkt A) des Invertertransistors (14) der ersten Stufe angeschlossen ist, dessen Drain mit einer positiven Spannung ($V_{DD}$) versorgt wird und dessen Source über mindestens eine Shiftdiode (16) mit einem Rückholtransistor (18) verbunden ist, dessen Gate und Source mit einer negativen Spannung ($V_{SS}$) versorgt werden, wobei die am Drain des Rückholtransistors (18) abgegriffene Ausgangsspannung ($V_S$ – Punkt B) der zweiten Stufe an das Gate des Invertertransistors (14) der ersten Stufe rückgeschleift wird.

3. Digital-Analog-Wandler nach Anspruch 2, dadurch gekennzeichnet, daß der Invertertransistor (14) eine negative Schwellenspannung ($V_T$) uund eine konstante Steilheit ($G_O$) besitzt, und daß der als Source-Folgeschaltung ausgebildete Transistor die gleiche negative Schwellenspannung besitzt, während die Eingangstransistoren (1, 3, 5, 7) eine positive Schwellenspannung nahe bei + 0,1 V besitzen.

4. Digital-Analog-Wandler nach Anspruch 2, dadurch gekennzeichnet, daß die Anzahl der Shiftdioden (16, 17) in der Shiftstufe von der Schwellenspannung ($V_T$) des als Source-Folgeschaltung ausgebildeten Transistors (15) abhängt.

5. Digital-Analog-Wandler nach Anspruch 2, dadurch gekennzeichnet, daß die Wahl der Steilheit (Go) des Invertertransistors (14) die Empfindlichkeit der Ausgangsspannung ($V_S$) bestimmt.

## Claims

1. A digital/analog converter having a high stability output voltage ($V_S$) and comprising a first stage constituted by a plurality of parallel-connected modulable loads which supply currents in geometrical progression to a single current to voltage transforming inverter transistor (14) whose source is grounded, each modulable load being constituted of a transistor (1, 3, 5, 7) whose gate constitutes an input ($L_0$, $L_1$, $L_2$, $L_3$) for the binary number, whose drain is fed with a positive voltage ($V_{DD}$) and whose source is connected to the inverter transistor via a saturable load (2, 4, 6, 8), the drain of the latter transistor constituting the output (point A) of the first stage, characterized in that the digital/analog converter comprises a second stage, which is interconnected between a positive feed voltage ($V_{DD}$) and a negative feed voltage ($V_{SS}$) whose input is connrected to the output (point A) of the first stage, whose output (point B) delivers a stabilized output voltage ($V_S$) which is looped back (point B) to the gate of the inverter (14) of the first stage.

2. A digital/analog converter according to claim 1, characterized in that the second stage is a shifting unit constituted by a first transistor (15) mounted in source-follower mode, whose gate is a connected to the drain (point A) of the inverter transistor (14) of the first stage, whose drain is supplied with a positive voltage ($V_{DD}$) and whose source is connected via at least one shift diode (16) to a repeat transistor (18), whose gate and source are fed with a negative voltage ($V_{SS}$), the output voltage ($V_S$) of the second stage, derived (point B) from the drain of the repeat transistor (18), being looped back to the gate of the inverter transistor (14) of the first stage.

3. A digital/analog converter according to claim 2, characterized in that the inverter transistor has a negative threshold voltage ($V_T$) and a constant transconductance ($G_O$), and in that the transistor (15) mounted in source-follower mode has the same negative threshold voltage, the input transistors (1, 3, 5, 7) having a positive threshold voltage close to + 0,1 V.

4. A digital/analog converter according to claim 2, characterized in that the number of shift diodes (16, 17) in the shifting stage depends upon the threshold voltage ($V_T$) of the transistor (15) mounted in source-follower mode.

5. A digital/analog converter according to claim 2, characterized in that the choice of the transconductance ($G_O$) of the inverter transistor determines the sensivity of the output voltage ($V_S$).

# FIG.1

# FIG.2